# FASCICULE DE BREVET EUROPEEN

(11) **EP 3 646 371 B1**
(45) Date de publication et mention de la délivrance du brevet: **14.04.2021**
(21) Numéro de dépôt: 18749844.9
(22) Date de dépôt: 29.06.2018
(51) Int. Cl.: H01L 21/02, H01L 21/311, H01L 21/3213, C11D 3/04, C11D 3/20, C11D 11/00

(54) **COMPOSITION CHIMIQUE DE NETTOYAGE POUR LE RETRAIT D'UNE COUCHE DE PASSIVATION AMORPHE A LA SURFACE DE MATERIAUX CRISTALLINS**
CHEMISCHE REINIGUNGSZUSAMMENSETZUNG ZUR ENTFERNUNG EINER AMORPHEN PASSIVIERUNGSSCHICHT AUF DER OBERFLÄCHE VON KRISTALLINEN MATERIALIEN
CHEMICAL CLEANING COMPOSITION FOR REMOVING AN AMORPHOUS PASSIVATION LAYER AT THE SURFACE OF CRYSTALLINE MATERIALS

(30) Priorité: 30.06.2017 FR 1756215
(43) Date de publication de la demande: 06.05.2020
(73) Titulaire: Technic France, 93200 Saint Denis (FR)
(72) Inventeur: PIZZETTI, Christian, 38490 La Batie Divisin (FR); AUDOUIN, Marine, 38000 Grenoble (FR); DAVIOT, Jérôme, 71880 Chatenoy Le Royal (FR); PIALOT, Nicolas, 75015 Paris (FR); VERNIN, Philippe, 75166 Paris (FR)
(74) Mandataire: Regimbeau
(86) Numéro de dépôt international: PCT/FR2018/051607
(87) Numéro de publication internationale: WO 2019/002789

(56) Documents cités:
- JP-A- S6 064 437
- US-A1- 2006 228 890
- US-A1- 2010 048 443

## Description

### DOMAINE DE L'INVENTION

La présente invention concerne une composition chimique de nettoyage permettant la dissolution d'une couche amorphe de surface composée de métaux ou matériaux semi-conducteurs sous leur forme oxydée afin d'en permettre le retrait de manière sélective vis-à-vis de couches constituées d'autres matériaux, susceptibles d'être exposées à ladite composition. La composition en question est tout particulièrement adaptée au retrait d'une couche de passivation amorphe résultant de la mise en œuvre d'un procédé de gravure plasma très fréquemment utilisé en microélectronique.

### ETAT DE LA TECHNIQUE

La mise en œuvre d'un procédé de gravure par voie sèche consiste à exposer une couche d'un matériau défini, par exemple une couche d'un métal, à un plasma ionique, afin de graver ladite couche, c'est-à-dire d'en attaquer certaines zones prédéterminées afin de permettre un retrait local de matière au niveau de ces zones. Il existe principalement trois types de gravure sèche, à savoir la gravure ionique (en anglais « Ion Beam Etching » avec l'acronyme IBE), la gravure ionique réactive (en anglais « Reactive Ion Etching », avec l'acronyme RIE), et la gravure par attaque chimique gazeuse. Toutes les trois sont réalisées à partir de la formation d'un plasma d'ions. Lors du traitement, les gaz à l'état de plasma convertissent le matériau à graver de l'état solide à l'état gazeux, pour en permettre l'élimination, c'est-à-dire son retrait de la couche de matériau à graver.

La gravure plasma est tout particulièrement, mais non exclusivement, utilisée dans le cadre de la fabrication de dispositifs microélectroniques, où la fabrication de circuits intégrés requiert des étapes successives de dépôt et de gravure de différentes couches afin d'élaborer des dispositifs élémentaires et de les lier entre eux. De tels dispositifs électroniques sont en particulier des transistors MOS (acronyme du terme anglo-saxon « Metal Oxide Semiconductor ») formés d'une couche d'oxyde agencée entre une couche de métal et une couche d'un matériau semi-conducteur, ou des condensateurs MIM (acronyme du terme anglo-saxon « Métal Insulator Métal ») formés d'une couche d'isolant agencée entre deux couches de matériaux conducteurs. Pour des raisons technologiques, la constante diélectrique de l'isolant doit être la plus élevée possible. Les matériaux tels que le pentoxyde de tantale (Ta₂O₅), le dioxyde d'hafnium (HfO₂) et le dioxyde de zirconium (ZrO₂) sous leur forme cristalline sont utilisés pour la formation de ces condensateurs, et sont connus sous la dénomination anglo-saxonne « high-k materials ».

La réalisation d'une gravure par plasma engendre la formation de résidus de gravure qui se déposent principalement sur les parois latérales, ou flancs, de la couche gravée. Ces résidus de gravure se présentent sous la forme d'une couche amorphe de surface composée de métaux ou matériaux semi-conducteurs sous leur forme oxydée qui résultent de l'interaction des ions du plasma avec la ou les couche(s) à graver.

Les résidus de gravure peuvent par exemple se déposer sur la surface latérale interne d'un « puits » de gravure, ou bien sur les surfaces latérales externes d'un motif, ce dernier correspondant à une zone non gravée localisée de part et d'autre de zones gravées. Ils forment alors une couche de passivation qui s'oppose à la gravure par plasma.

La couche de passivation est formée soit par la redéposition de produits de gravure peu volatils, soit par l'introduction dans le plasma d'un gaz polymérisant capable de former des résidus de gravure. On distingue plusieurs mécanismes physico-chimiques pour la formation d'une couche de passivation, parmi lesquels les mécanismes récurrents suivants.

Selon un premier mécanisme, les ions du plasma réagissent avec la couche à graver et forment une couche réactive sur la surface à graver sur les flancs des motifs. Selon un deuxième mécanisme, les produits de gravure volatils issus de la réaction des ions du plasma avec la couche à graver se déposent sur les flancs des motifs, puis réagissent avec l'environnement chimique afin de former la couche de passivation, par exemple par oxydation. Selon un troisième mécanisme, les résidus sont directement produits par le plasma et se déposent directement sur les flancs des motifs, sans participation de la couche réactive.

Par ailleurs, la gravure par plasma possède l'avantage d'être relativement anisotrope, la gravure étant majoritairement dirigée selon le flux d'ions du plasma, c'est-à-dire selon une direction sensiblement perpendiculaire à la couche à graver du substrat.

Cependant, bien que l'anisotropie de gravure soit assurée par le flux d'ions directionnel, il existe une vitesse de gravure latérale non négligeable du fait des mécanismes isotropes de gravure de nature chimique.

Or la vitesse de gravure latérale est la résultante de deux composantes : la gravure horizontale des flancs du substrat, et la formation de la couche de passivation protectrice sur les flancs. Dès lors, en maitrisant la formation de la couche de passivation, il est possible de maximiser la gravure dans la direction du flux d'ions du plasma, et de minimiser la gravure latérale sensiblement perpendiculaire à la direction du flux d'ions du plasma. En pratique, le procédé de gravure par plasma est optimisé de manière à former une couche de passivation d'une épaisseur faible et contrôlée sur les flancs du substrat.

Dans tous les cas, qu'elle soit maitrisée ou non, la couche de passivation résulte de l'action même du plasma sur la couche à graver, et nécessite d'être éliminée après gravure.

Pour ce faire, il est connu de recourir à un nettoyage chimique par voie humide, dans lequel une composition chimique est appliquée au contact des résidus de gravure afin de les attaquer chimiquement et de les éliminer du substrat. Ce type de nettoyage est très répandu notamment du fait de sa relative facilité de mise en œuvre. En effet, il s'agit en pratique de mettre le substrat en contact avec la composition chimique pendant un temps suffisant pour permettre le retrait de la couche de passivation du substrat, ce temps de nettoyage dépendant de la nature et de l'épaisseur de la couche à éliminer et de la composition chimique. Il peut s'agir par exemple de tremper le substrat dans un bain chimique de la composition, ou bien dispenser la composition de manière dynamique sur le substrat en rotation sur un support adapté. Il est dès lors possible de traiter de nombreux substrats en parallèle, ce qui représente un gain de temps considérable et une réduction importante des coûts de production industriels.

Le choix de la composition chimique est effectué en fonction du matériau constitutif de la couche de passivation à retirer, et des matériaux des couches à protéger qui ne doivent pas être attaqués par la composition. Lorsque la couche de passivation est obtenue par redéposition de produits de gravure peu volatils (ce qui est notamment le cas pour le premier et le deuxième mécanisme précédents), le choix de la composition chimique dépend donc également du matériau constitutif de la couche gravée.

Il est ainsi nécessaire d'utiliser une composition chimique qui attaque efficacement les résidus de gravure tout en étant sélective vis-à-vis des autres matériaux avec lesquels elle est susceptible de rentrer en contact lors du nettoyage.

Il est connu d'utiliser de l'acide fluorhydrique pour le nettoyage chimique de substrat après gravure plasma. De manière plus générale, l'acide fluorhydrique est couramment utilisé pour la gravure humide d'oxydes métalliques et semi-conducteurs, et permet de dissoudre les oxydes métalliques et semi-conducteurs amorphes avec une grande efficacité. On précise qu'une structure amorphe correspond à une structure atomique désordonnée, par opposition à une structure cristalline qui est ordonnée selon un réseau cristallin. Le réseau cristallin confère de la rigidité à la structure et la rend beaucoup plus résistante aux attaques chimiques que la structure amorphe, et en particulier à l'acide fluorhydrique.

Il a également été constaté que des compositions comprenant de l'acide fluorhydrique et de l'acide acétique attaquent encore plus efficacement les oxydes métalliques amorphes qu'une composition d'acide fluorhydrique seul. A ce sujet, le document US 2016/0163533 décrit qu'une composition à base d'acide fluorhydrique, d'un acide organique tel que l'acide acétique, et d'eau, permet d'attaquer efficacement une couche d'oxydes de tantale sur un substrat en silicium, sans attaquer le silicium.

Les compositions chimiques précédentes sont efficaces pour attaquer des oxydes métalliques amorphes, tout en présentant une sélectivité relative vis-à-vis de certains métaux ou matériaux semi-conducteurs comme par exemple le silicium.

Cependant, aucune de ces compositions chimiques ne protège l'aluminium, si bien qu'une couche d'aluminium qui entre en contact avec la composition chimique est attaquée et retirée avec la couche d'oxyde métallique amorphe

US 2006/228890 A1 et US 2010/048443 A1 décrivent des compositions, et des procédés de nettoyage utilisant ces compositions pour retirer de substrats des couches de passivation comprenant des résidus de gravure résultant d'une gravure desdits substrats.

### EXPOSE DE L'INVENTION

L'invention a donc pour but de remédier aux inconvénients de l'art antérieur en proposant une composition chimique de nettoyage permettant le retrait d'une couche de passivation de manière sélective vis-à-vis de l'aluminium et du cuivre. En d'autres termes, la composition chimique proposée permet d'attaquer la couche de passivation tout en protégeant l'aluminium et le cuivre.

L'invention vise en particulier à proposer une composition chimique pour nettoyer un substrat formé d'une couche ou d'un empilement de couches après la gravure par plasma d'une ou plusieurs de ses couches constitutives, la composition permettant de retirer sélectivement une couche de passivation formée par l'interaction des ions du plasma avec la ou les couche(s) du substrat à graver vis-à-vis de l'aluminium et du cuivre.

A cette fin, selon un premier aspect, l'invention propose une composition chimique de nettoyage telle que définie dans la revendication 1.

Selon un mode de réalisation, la composition chimique est constituée uniquement, ou essentiellement, de l'acide faible, de l'acide fort, de l'acide fluorhydrique, et de l'eau.

Un autre but de l'invention est de proposer un procédé de nettoyage d'un substrat permettant le retrait sélectif d'une couche de passivation vis-à-vis de l'aluminium et du cuivre, dans lequel la composition chimique décrite précédemment est mise en œuvre.

A cette fin, selon un deuxième aspect, l'invention propose un procédé de nettoyage tel que défini dans la revendication 2, les revendications dépendantes définissant des caractéristiques supplémentaires.

La composition chimique et le procédé de nettoyage proposés s'appliquent particulièrement, mais non exclusivement, au retrait d'une couche de passivation dans le cadre de la fabrication de dispositifs microélectroniques.

Par « couche de passivation », on entend dans le présent texte une couche amorphe, formée naturellement ou artificiellement (par exemple dans le cas de résidus obtenus après une gravure plasma), constituée de métaux et/ou de matériaux semi-conducteurs sous leur forme oxydée (avec un nombre d'oxydation supérieur ou égal à 1), et pouvant comporter plusieurs éléments chimiques associés au(x) cation(s) du métal et/ou du matériau semi-conducteur tels que le fluor, le chlore, le phosphore, le soufre, l'oxygène, l'azote, ou encore le carbone.

Le substrat est formé d'une couche ou d'un empilement de couches constituées d'au moins deux matériaux différents. Les matériaux constitutifs des couches du substrat sont des métaux et des matériaux semi-conducteurs, ceux-ci pouvant être présents sous leur forme oxydée (avec un nombre d'oxydation supérieur ou égal à 1). Il peut s'agir de matériaux isolants, tels que des matériaux à haute constante diélectrique, dits « high-k », comme le pentoxyde de tantale (Ta₂O₅), le dioxyde d'hafnium (HfO₂) et le dioxyde de zirconium (ZrO₂), sous leur forme cristalline. Une ou plusieurs des couches constitutives du substrat sont gravées par plasma (et sont désignées dans la suite en tant que « couches gravées du substrat ») puis le substrat gravé est nettoyé avec la composition de l'invention afin de retirer la couche de passivation qui recouvre les flancs de la couche gravée

Selon l'invention, la couche de passivation comprend des résidus de gravure résultant d'une gravure du substrat, et la couche de passivation comprend un ou plusieurs des éléments chimiques choisi parmi le tantale, l'hafnium et le zirconium.

### DESCRIPTION DES FIGURES

D'autres avantages et caractéristiques de l'invention apparaîtront à la lecture de la description suivante donnée à titre d'exemple illustratif et non limitatif, en référence aux Figures annexées qui représentent :
- la Figure 1, un graphique représentant les vitesses relatives de retrait de l'aluminium et de l'oxyde thermique de silicium en fonction de la teneur en eau présente dans une composition chimique selon un mode de réalisation de l'invention comprenant de l'acide acétique, de l'acide méthane sulfonique, du fluorure d'ammonium, et de l'eau ;
- la Figure 2, un graphique représentant les vitesses relatives de retrait de l'aluminium et de l'oxyde thermique de silicium en fonction de la teneur en fluorure présent dans une composition chimique selon un mode de réalisation de l'invention comprenant de l'acide acétique, de l'acide méthane sulfonique, du fluorure d'ammonium, et de l'eau ;
- les Figures 3 et 4, des graphiques représentant les vitesses relatives de retrait de l'aluminium et de l'oxyde thermique de silicium en fonction de la teneur en acide méthane sulfonique présent dans une composition chimique comprenant de l'acide acétique, de l'acide méthane sulfonique, du fluorure d'ammonium, et de l'eau, pour deux teneurs différentes en fluorure d'ammonium relativement à l'acide méthane sulfonique ;
- la Figure 5, un schéma d'un plot d'aluminium (appelé généralement « pad » selon la terminologie anglo-saxonne) après gravure plasma, comprenant plusieurs couches de matériaux ainsi que des résidus de gravure riches en tantale sur les flancs ;
- les Figures 6A, 6B, et 6C, des photos par microscopie électronique à balayage du plot d'aluminium de la Figure 5 avant et après retrait des résidus de gravure par nettoyage avec une composition chimique selon un mode de réalisation de l'invention ;
- la Figure 7, un schéma d'un condensateur MIM à base de Ta₂O₅ après gravure plasma, comprenant plusieurs couches de matériaux ainsi que des résidus de gravure sur les flancs ;
- les Figures 8A, 8B, et 8C, des photos par microscopie électronique à balayage et en transmission du condensateur MIM de la Figure 7 avant et après retrait des résidus de gravure par nettoyage avec une composition chimique selon un mode de réalisation de l'invention ;
- La Figure 9, un schéma d'un substrat d'oxyde de silicium après gravure plasma, dans lequel la paroi latérale d'un puits est recouverte par des résidus de gravure ;
- les Figures 10A, 10B et 10C, des photos par microscopie électronique à balayage du substrat de la Figure 9 avant et après retrait des résidus de gravure par nettoyage avec une composition chimique selon un mode de réalisation de l'invention.

### DESCRIPTION DETAILLEE DE MODES DE REALISATION DE L'INVENTION

La composition chimique de nettoyage permet de retirer efficacement une couche de passivation d'un substrat, de manière sélective vis-à-vis de l'aluminium et du cuivre. Elle permet notamment de nettoyer un substrat après la gravure par plasma d'une ou plusieurs couche(s) constitutive(s) du substrat.

La composition chimique comprend de l'acide fluorhydrique dans un solvant constitué d'un acide faible. L'acide fluorhydrique permet de dissoudre les métaux et les matériaux semi-conducteurs sous forme oxydée de la couche de passivation.

L'acide fluorhydrique est avantageusement présent dans la composition à une teneur comprise entre 0,2% en poids et 2% en poids par rapport au poids de la composition. En effet, avec une teneur inférieure à 0,2% en poids, la dissolution par l'acide fluorhydrique des métaux et des matériaux semi-conducteurs oxydés est réduite, ce qui limite le retrait de la couche de passivation. Avec une teneur supérieure à 2% en poids, l'agressivité de l'acide fluorhydrique sur la couche gravée du substrat, et en particulier sur les métaux tels que l'aluminium et le cuivre, devient plus importante et difficile à contrôler, et la couche gravée est alors beaucoup moins protégée.

L'acide fluorhydrique peut provenir du fluorure d'hydrogène (HF) et/ou d'autres sources de fluor connues telles que les sels d'ammonium par exemple.

L'acide faible est choisi parmi l'acide acétique, et le mélange d'acide acétique et d'acide formique, et est présent dans la composition à une teneur comprise entre 20% en poids et 95% en poids, de préférence entre 50% en poids et 80% en poids, par rapport au poids total de la composition. L'acide formique et l'acide acétique permettent de solvater efficacement l'acide fluorhydrique et ses sels comme le sel d'ammonium.

Lorsque l'acide faible est un mélange d'acide acétique et d'acide formique, leurs teneurs respectives dans la composition sont ajustées afin que la teneur en acide faible dans la composition soit telle que décrite précédemment.

L'acide fluorhydrique est acidifié par un acide fort non oxydant, choisi parmi l'acide méthane sulfonique, et le mélange d'acide méthane sulfonique et d'acide chlorhydrique.

L'acide méthane sulfonique est préféré de par sa grande stabilité physique (il possède une très faible pression de vapeur) et sa capacité à former des complexes stables avec de nombreux métaux.

L'acide fort non oxydant est avantageusement présent dans la composition à une teneur comprise entre 5% en poids et 50% en poids, de préférence entre 15% en poids et 50% en poids, par rapport au poids de la composition. En effet, une teneur inférieure à 5% en poids engendre une forte diminution de la protection de la couche gravée, et en particulier des métaux tels que l'aluminium et le cuivre. Avec une teneur supérieure à 50% en poids, la composition devient plus visqueuse, ce qui réduit grandement le mouillage du substrat par la composition, et réduit ainsi l'efficacité de la composition quant à l'attaque de la couche de passivation et quant à la protection de la couche gravée.

Lorsque l'acide fort non oxydant est un mélange d'acide méthane sulfonique et d'acide chlorhydrique, leurs teneurs respectives dans la composition sont ajustées afin que la teneur en acide fort non oxydant dans la composition soit telle que décrite précédemment.

L'acide méthane sulfonique a une concentration comprise entre 60% en poids et 80% en poids, et l'acide chlorhydrique a une concentration comprise entre 30% en poids et 40% en poids.

Le mélange de l'acide acétique avec l'acide méthane sulfonique permet d'aboutir à un retrait sélectif de la couche de passivation vis-à-vis de la couche gravée, et en particulier des métaux tels que l'aluminium et le cuivre.

La composition chimique comprend de l'eau pour faciliter la dissolution de l'acide fluorhydrique dans le solvant. L'eau permet par ailleurs d'hydrater la surface du substrat, et ainsi d'hydrater la surface de la couche de passivation, ce qui améliore l'efficacité de la composition.

La teneur en eau est inférieure ou égale à 20% en poids par rapport au poids de la composition. En effet, une teneur supérieure à 20% en poids engendre les mêmes effets qu'une teneur trop élevée en acide fluorhydrique, à savoir que l'agressivité de l'acide fluorhydrique sur la couche gravée devient plus importante et difficile à contrôler, et que la couche gravée est par conséquent beaucoup moins protégée.

Une teneur en eau supérieure ou égale à 2% en poids par rapport au poids de la composition permet en outre d'obtenir une hydratation satisfaisante du substrat.

Une composition comprenant uniquement un acide fort non oxydant et de l'acide fluorhydrique, avec éventuellement de l'eau, aboutit à un mauvais mouillage du substrat. C'est tout particulièrement le cas d'une composition comprenant de l'acide méthane sulfonique et de l'acide fluorhydrique, sans acide faible. La présence d'un acide faible permet d'obtenir un mouillage satisfaisant du substrat pour permettre un retrait optimal d'une couche de passivation du substrat.

Une composition comprenant de l'acide acétique en tant qu'acide faible, de l'acide méthane sulfonique en tant qu'acide fort, de l'acide fluorhydrique, et de l'eau, permet de mouiller efficacement le substrat. De plus, la présence conjointe de l'acide acétique et de l'acide méthane sulfonique permet de réduire fortement voire de faire disparaitre les ions [HF₂]⁻, responsables de la corrosion, du milieu réactionnel.

Selon le procédé de nettoyage de l'invention, la composition chimique décrite précédemment est mise au contact de la couche de passivation pendant une durée suffisante pour permettre le retrait de ladite couche de passivation du substrat. Pour ce faire, on pourra par exemple tremper le substrat dans un bain de la composition chimique pendant une durée prédéterminée. La composition attaque la couche de passivation de manière sélective vis à vis de la couche gravée. En d'autres termes, l'attaque de la couche gravée par la composition est négligeable devant celle de la couche de passivation.

On a déjà décrit que lorsque la couche gravée contient de l'aluminium ou du cuivre, ces derniers ne sont attaqués que de manière négligeable par la composition comparativement à la couche de passivation.

Il en est de même pour les métaux cristallins et/ou matériaux semi-conducteurs cristallins, éventuellement oxydés, que contient la couche gravée. En effet, leur réseau cristallin confère de la rigidité à leur structure et les rend beaucoup plus résistants aux attaques chimiques, en particulier à l'acide fluorhydrique et à la composition de l'invention, comparativement à ces mêmes matériaux de structure amorphe.

Lors de sa mise en contact avec la couche de passivation, la composition chimique est avantageusement portée à une température comprise entre 20°C et 40°C, de préférence entre 20°C et 30°C. La cinétique de la réaction de la composition chimique avec la couche de passivation est ainsi augmentée par rapport à la température ambiante, ce qui permet de réduire le temps de mise en œuvre du procédé de nettoyage.

La couche gravée comprend notamment un des éléments suivants : aluminium, cuivre, titane, tantale.

La couche de passivation comprend un ou plusieurs des éléments chimiques suivants : tantale, hafnium, zirconium.

### EXEMPLES

### I. Influence des teneurs en acide fluorhydrique, en acide méthane sulfonique, et en eau sur la vitesse de gravure de l'aluminium et de SiO₂ thermique.

On fournit un substrat (ou « wafer » en anglais) en silicium comprenant une couche d'oxyde de silicium (SiO₂) thermique (résultant d'un recuit à très haute température) d'une épaisseur de 200 Angström formée à la surface du substrat. Le substrat est recouvert d'une couche d'aluminium (Al) d'une épaisseur de 5500 Angström déposée par dépôt physique en phase vapeur (en anglais « Physical Vapor Deposition », avec l'acronyme PVD) sur la couche de SiO₂ thermique.

Pour chacun des exemples I.1, I.2 et I.3, on découpe des coupons de 2 centimètres par 2 centimètres que l'on immerge pendant quelques minutes sous légère agitation dans les différentes compositions Les coupons sont ensuite retirés puis rincés vivement à l'eau déionisée pendant au moins une minute, puis séchés à l'air comprimé.

On détermine ensuite les vitesses de gravure de l'aluminium et de SiO₂ selon les méthodes suivantes :
- La vitesse de gravure de l'aluminium est déterminée par mesure quatre pointes avec un appareil de mesure quatre pointes de la marque 302 Lucas Labs. Cette méthode connue consiste à imposer un courant électrique entre un premier couple de pointes et à mesurer une tension électrique entre un second couple de pointes. Elle permet ainsi de mesurer la résistance électrique de la couche d'aluminium avant et après immersion de l'échantillon dans la composition, et d'en déduire l'épaisseur de la couche d'aluminium qui a été retirée. On réalise une moyenne de 5 valeurs de résistance carrée avant et après immersion des échantillons afin de déterminer l'épaisseur d'aluminium restante et en déduire la vitesse de gravure.
- La vitesse de gravure de SiO₂ est déterminée par réflectométrie avec un réflectomètre de la marque Ocean Optics, modèle Thin Film NanoCalc Reflectometry. Cette méthode connue consiste à envoyer un signal dans la couche de SiO₂ puis à analyser le signal de retour, afin de déduire l'épaisseur de la couche de SiO₂ avant et après immersion de l'échantillon dans la composition, et d'en déduire l'épaisseur de la couche de SiO₂ qui a été retirée. On réalise une moyenne de 5 valeurs de réflectométrie avant et après immersion des échantillons afin de déterminer l'épaisseur de SiO₂ restante.

Les vitesses de gravure sont relatives en ce qu'elles sont exprimées par rapport à la vitesse de gravure de référence obtenue avec une composition de référence choisie expérimentalement.

### I.1. Influence de la teneur en eau

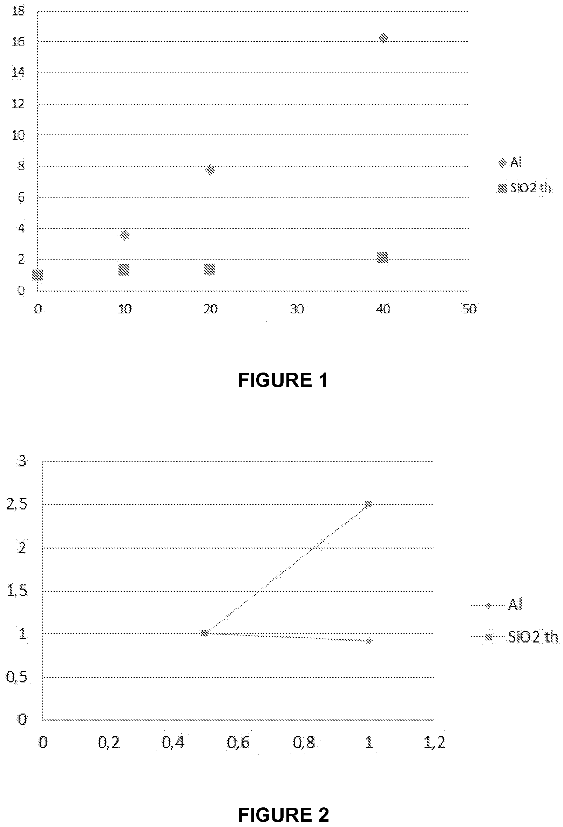

La Figure 1 représente les vitesses relatives de gravure de l'aluminium et de SiO₂ (rapport relatif sans unité) en fonction de la quantité d'eau ajoutée (en pourcentage massique) dans une composition comprenant initialement 74% en poids d'acide acétique, 23% en poids d'acide méthane sulfonique (concentration de 70%), 1,2% en poids de fluorure d'ammonium, et 1,8% en poids d'eau (point d'abscisse 0 sur le graphique de la Figure 1).

On constate que l'ajout d'eau dans la composition provoque une forte augmentation de la vitesse relative de gravure de l'aluminium. En effet, par rapport à la composition initiale, la vitesse de gravure de l'aluminium est multipliée par 3,5 à 10% d'eau, 7,8 à 20% d'eau, et 16,2 à 40% d'eau.

La vitesse relative de gravure de SiO₂ augmente également bien que beaucoup plus faiblement. Elle est multipliée par 1,5 à 10% d'eau, 1,7 à 20% d'eau, et 2,2 à 40% d'eau.

Par conséquent, afin de maintenir une protection satisfaisante de l'aluminium et de SiO₂, il est nécessaire de maintenir une teneur en eau inférieure ou égale à 20% en poids dans la composition.

### I.2. Influence de la teneur en acide fluorhydrique

La Figure 2 représente les vitesses relatives de gravure de l'aluminium et de SiO₂ (rapport relatif sans unité) en fonction de la concentration relative en fluorure (en pourcentage massique) dans une composition d'acide acétique, acide méthane sulfonique, et eau, où les teneurs en acide méthane sulfonique et en eau sont fixées respectivement à 33% en poids et 9,9% en poids, et où la teneur en acide acétique varie avec la teneur en fluorure.

On constate que l'augmentation en fluorure provoque une forte augmentation de la vitesse relative de gravure de SiO₂, celle-ci étant multipliée par 2,5 entre 0,5% et 1% d'acide fluorhydrique.

L'augmentation en fluorure provoque une faible baisse de la vitesse relative de gravure de l'aluminium, celle-ci étant multipliée par 0,9 entre 0,5% et 1% d'acide fluorhydrique.

Par conséquent, afin de maintenir une protection satisfaisante de SiO₂, il est nécessaire de maintenir une teneur en acide fluorhydrique inférieure ou égale à 2% en poids dans la composition.

### I.3. Influence de la teneur en acide méthane sulfonique

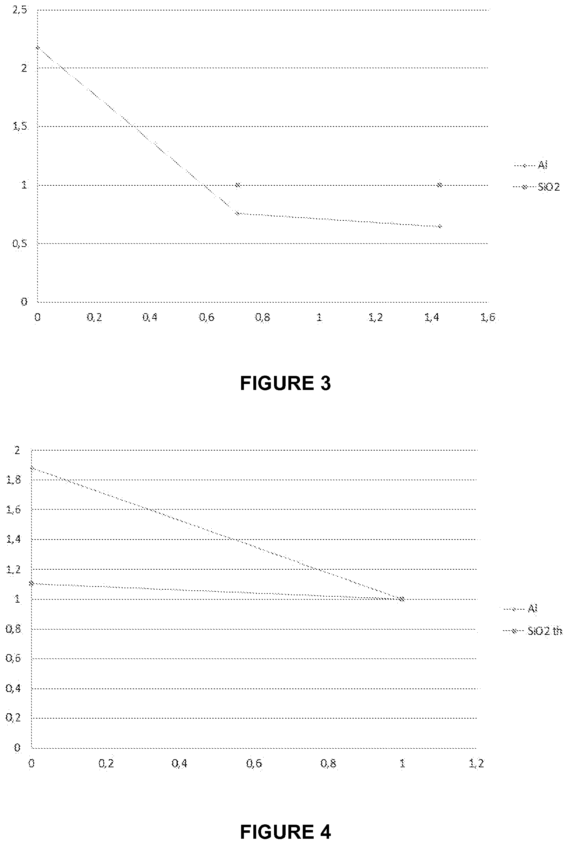

Les Figures 3 et 4 représentent les vitesses relatives de gravure de l'aluminium et de SiO₂ (rapport relatif sans unité) en fonction de la concentration relative en acide méthane sulfonique (en pourcentage massique) dans des compositions d'acide acétique, acide fluorhydrique, et eau, où :
- pour la Figure 3, les teneurs en acide fluorhydrique et en eau sont fixées respectivement à 0,89% en poids et 10% en poids, et la teneur en acide acétique varie avec la teneur en acide méthane sulfonique ;
- pour la Figure 4, les teneurs en acide fluorhydrique et en eau sont fixées respectivement à 0,65% en poids et 8,7% en poids, et la teneur en acide acétique varie avec la teneur en acide méthane sulfonique

Ces compositions ne sont pas représentatives de la composition de l'invention.

Pour la Figure 3, on constate que l'augmentation en acide méthane sulfonique jusqu'à 0,7% provoque une forte diminution de la vitesse relative de gravure de l'aluminium, celle-ci passant d'un rapport de 2,2 à 0,7, puis une diminution plus faible jusqu'à 1,4% avec un rapport de 0,6. La vitesse relative de gravure de SiO₂ reste quant à elle sensiblement constante à partir de 0,7% d'acide méthane sulfonique.

Pour la Figure 4, on constate que l'augmentation en acide méthane sulfonique provoque une forte diminution de la vitesse relative de gravure de l'aluminium, celle-ci passant d'un rapport de 1,9 à 1 entre 0% et 1% d'acide méthane sulfonique. La vitesse relative de gravure de SiO₂ diminue faiblement et passe d'un rapport de 1,1 à 1 entre 0% et 1% d'acide méthane sulfonique.

Par conséquent, l'ajout d'acide méthane sulfonique permet d'améliorer significativement la protection de l'aluminium.

### 11.1. Nettoyage d'un plot de connexion en aluminium après gravure plasma

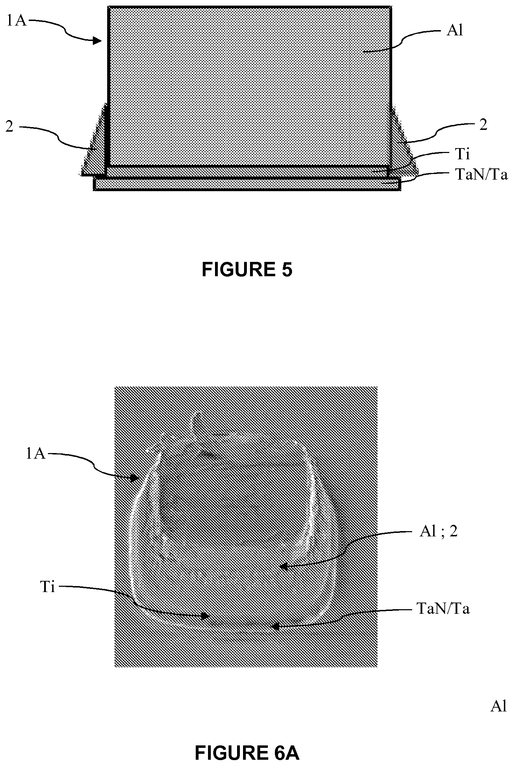

On fournit un substrat en silicium comprenant un empilement de couches de matériaux, dans lequel on grave par plasma des plots (ou « pad » selon la terminologie anglo-saxonne) de connexion en aluminium, dont un plot 1A est représenté de manière schématique sur la Figure 5. En pratique, un tel plot correspond à un dernier niveau de connexion qui repose sur de nombreux autres niveaux d'interconnexions du substrat. La dimension du plot 1A est d'environ 2 micromètres de long x 2 micromètres de large à sa base. Il comprend successivement une couche de tantale et de nitrure de tantale (Ta/TaN), une couche de titane (Ti) et une couche d'aluminium (Al) d'une épaisseur de 1 micromètre déposée par dépôt physique en phase vapeur (en anglais « Physical Vapor Deposition », avec l'acronyme PVD).

Les différentes couches constitutives des plots sont gravées simultanément par gravure plasma avec un gaz de gravure qui génère des résidus 2 sur les flancs des plots. Ces résidus 2 de gravure sont formés à partir des différents éléments des couches gravées, et forment une couche de passivation qui réduit l'impact de la gravure. La composition chimique des résidus de gravure est la suivante : Ta_{w}TiₓAl_{y}O_{z}, avec w, x, y, z les indices stœchiométriques des différents éléments chimiques.

Dans la structure obtenue après gravure plasma sont découpés des coupons de 2 centimètres par 2 centimètres, comprenant chacun une pluralité de plots, à l'aide d'une pointe en diamant.

Les coupons de plots en aluminium sont plongés dans deux mélanges à concentrations équivalentes en fluorure :
- un mélange comprenant 1% en poids d'acide fluorhydrique dans de l'acide acétique,
- un mélange correspondant à la composition selon un mode de réalisation de l'invention, comprenant 74% en poids d'acide acétique, 23% en poids d'acide méthane sulfonique (concentration de 70%), 1,2% en poids de fluorure d'ammonium, et 1,8% en poids d'eau.

Après immersion pendant 3 minutes à température ambiante sous légère agitation et séchage, les coupons sont observés au microscope électronique à balayage afin d'évaluer l'efficacité du nettoyage.

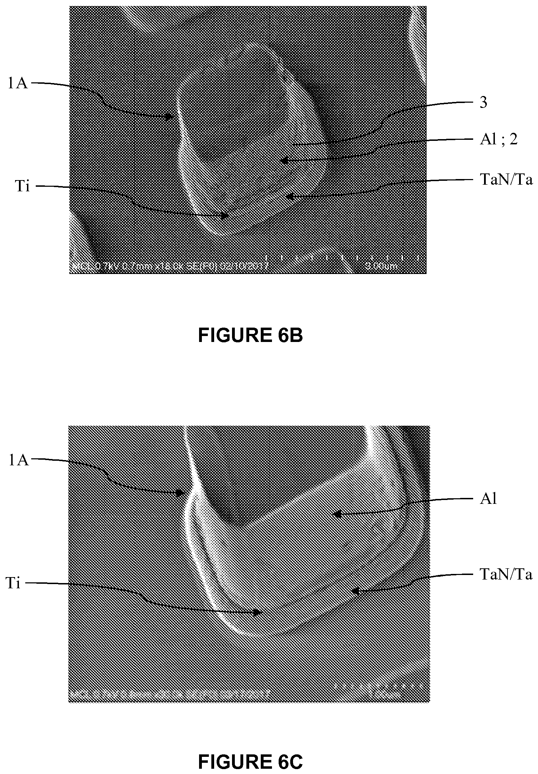

Les images obtenues sont représentées sur les Figures 6B, et 6C. La Figure 6A sert de référence et représente un coupon avant nettoyage.

Sur la Figure 6A, on observe que la couche de passivation 2, visible par les irrégularités de surface qu'elle comporte, recouvre les flancs du plot. La portion de couche de passivation qui recouvre la partie inférieure du plot au niveau des couches de Ti et Ta/TaN est plus riche en Ti et Ta, tandis que la portion de couche de passivation qui recouvre la partie supérieure du plot au niveau des couches Al est plus riche en Al.

Sur la Figure 6B, on observe que la couche de passivation 2 est encore bien présente, ce qui indique que le mélange n'est pas assez efficace. De plus, des trous 3 dans l'aluminium dans la partie haute du plot indiquent une corrosion localisée de l'aluminium (ce phénomène est connu sous l'appellation « pitting » selon la terminologie anglo-saxonne), ce qui montre que le mélange est trop agressif vis-à-vis de l'aluminium.

Sur la Figure 6C, on observe qu'il n'y a plus de couche de passivation 2, celle-ci ayant été entièrement retirée par la composition de l'invention lors du nettoyage. Ainsi, l'ajout d'acide méthane sulfonique à un mélange d'acide acétique et d'acide fluorhydrique permet d'augmenter fortement l'efficacité du nettoyage ainsi que la protection de l'aluminium.

L'attaque des couches de Ti et TaN/Ta est négligeable, du fait de leur structure cristalline.

Les vitesses de gravure de l'aluminium et de SiO₂ thermique ont été déterminées par mesure 4 pointes et réflectométrie selon les protocoles détaillés dans l'exemple (I), et sont égales à 17 Angström par minute pour l'aluminium et 12 Angström par minute pour SiO₂ thermique. Cette très faible perte se traduit par le fait que, visuellement, la morphologie du plot reste inchangée.

### II.2. Nettoyage d'un condensateur MIM à base de Ta₂O₅ après gravure plasma

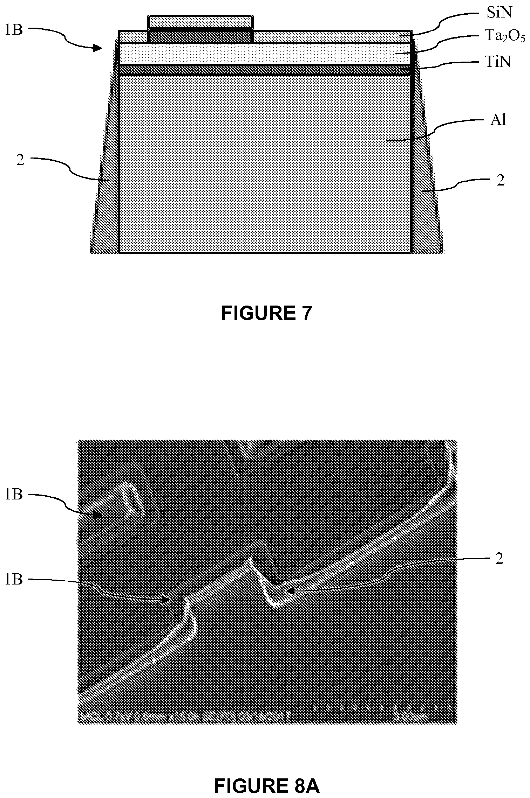

On fournit un substrat comprenant un empilement de couches de matériaux, dans lequel on grave par plasma des condensateurs MIM, dont un condensateur MIM référencé 1B est représenté de manière schématique sur la Figure 7. Un condensateur MIM 1B se présente sous la forme d'un plot de dimension d'environ 5 micromètres de large x 3 micromètres de long à sa base. Il comprend une couche d'aluminium (Al) d'une épaisseur de 600 Angström déposée par dépôt physique en phase vapeur sur le substrat, surmontée d'une couche de nitrure de titane (TiN), une couche de pentoxyde de tantale (Ta₂O₅) (matériau isolant à haute constante diélectrique) agencée sur la couche de TiN, et une couche de nitrure de silicium (SiN) agencée sur la couche de Ta₂O₅.

De manière analogue aux plots de connexion en aluminium, les différentes couches constitutives des condensateurs MIM sont gravées simultanément par gravure plasma avec un gaz de gravure qui génère des résidus 2 sur les flancs des MIM. Ces résidus 2 de gravure sont formés à partir des différents éléments des couches gravées, et forment une couche de passivation qui réduit l'impact de la gravure. La composition chimique des résidus de gravure est la suivante : TaᵥAl_{w}Ti_{y}NₓSi_{y}O_{z}, avec v, w, x, y, z les indices stœchiométriques des différents éléments chimiques.

Dans la structure obtenue après gravure plasma sont découpés des coupons de 2 centimètres par 2 centimètres, comprenant chacun une pluralité de MIM, à l'aide d'une pointe en diamant.

Les coupons de MIM sont plongés dans la composition selon un mode de réalisation de l'invention, dont les constituants et leur teneur sont identiques à la composition utilisée dans l'exemple II.A pour les plots en aluminium. La composition comprend 74% en poids d'acide acétique, 23% en poids d'acide méthane sulfonique (concentration de 70%), 1,2% en poids de fluorure d'ammonium, et 1,8% en poids d'eau.

Après immersion pendant 3 minutes à température ambiante sous légère agitation et séchage, les coupons sont observés au microscope électronique à balayage afin d'évaluer l'efficacité du nettoyage.

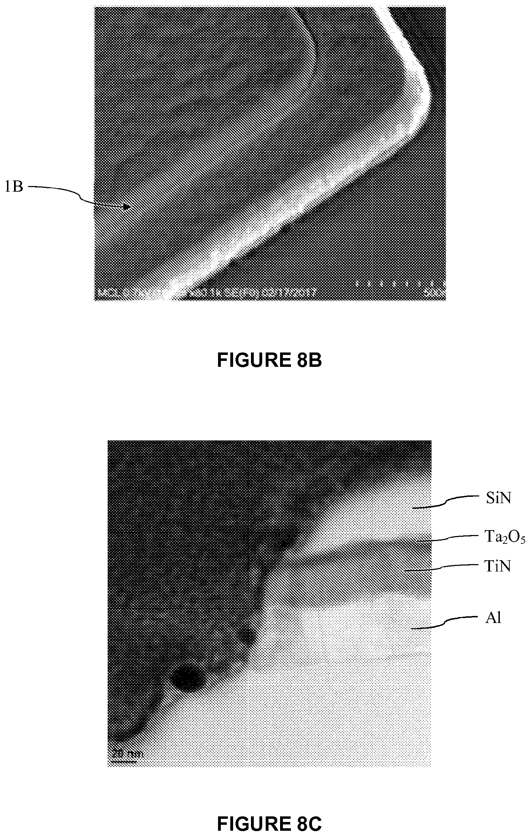

L'image obtenue est représentée sur la Figure 8B. La Figure 8A sert de référence et représente un coupon avant nettoyage.

Sur la Figure 8A, on observe que la couche de passivation 2, visible sous la forme d'un film clair, recouvre les flancs du condensateur MIM sur toute leur longueur.

Sur la Figure 8B, on observe qu'il n'y a plus de couche de passivation, celle-ci ayant été entièrement retirée par la composition de l'invention lors du nettoyage. De plus, il n'y a pas de signe visible d'attaque de l'aluminium.

La Figure 8C représente un coupon observé au microscope électronique en transmission avec sonde ionique focalisée (en anglais « Focused Ion Beam », avec l'acronyme FIB), à l'échelle du nanomètre. On n'observe aucun recul de l'aluminium, ni de TiN et Ta₂O₅, et seulement un très léger recul de SiN.

La composition a donc attaqué et permis le retrait de la couche de passivation de manière sélective vis-à-vis de l'aluminium. L'attaque des couches de TiN, Ta₂O₅, et SiN est négligeable, du fait de leur structure cristalline.

Le remplacement de la couche de Ta₂O₅ par les matériaux à haute constante diélectrique que sont le dioxyde d'hafnium (HfO₂) et le dioxyde de zirconium (ZrO₂) aboutit au même résultat, à savoir qu'une couche correspondante de HfO₂ ou de ZrO₂ au sein de la présente structure MIM n'est pas attaquée par la composition de l'invention.

La vitesse de gravure de l'aluminium a été déterminée par mesure 4 pointes selon le protocole détaillé dans l'exemple (I), et est égale à 17 Angström par minute. Cette très faible perte se traduit par le fait que, visuellement, la morphologie du plot reste inchangée.

### III. Nettoyage d'un puits après gravure plasma

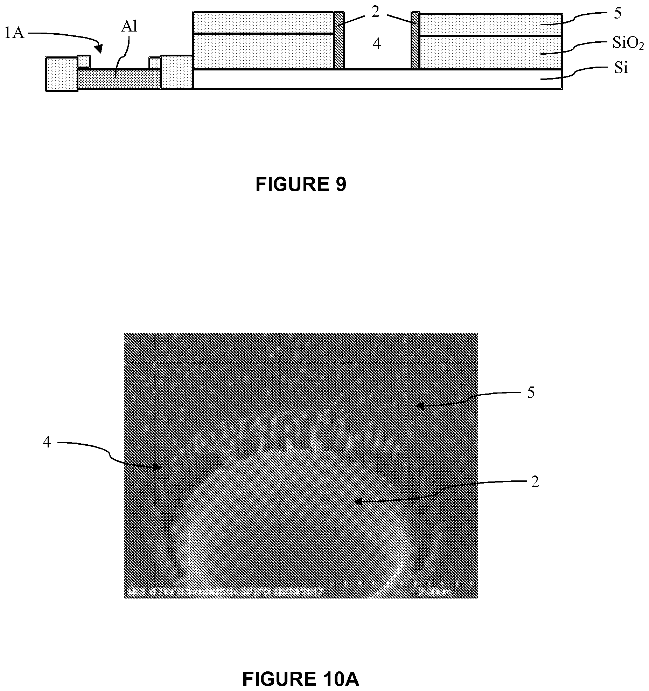

Ce procédé de nettoyage n'est pas représentatif du procédé de l'invention. On fournit un substrat en silicium (Si) comprenant une couche de SiO₂ d'environ 3 micromètres d'épaisseur recouverte d'une photorésine 5 servant de masque de gravure afin de retirer sélectivement une portion de la couche de SiO₂. La structure est représentée de manière schématique sur la Figure 9. La gravure plasma de SiO₂ a provoqué la formation d'une couche de passivation 2 sur la paroi latérale du puits 4 de gravure.

La composition du gaz de gravure est : CₓF_{y} avec x et y les indices stœchiométriques des différents éléments chimiques.

La composition des résidus 2 de gravure formant la couche de passivation est : Si_{w}AlₓO_{y}F_{z}, avec w, x, y et z les indices stœchiométriques des différents éléments chimiques.

On réalise le nettoyage de la structure précédente afin de retirer la couche de passivation du puits, avec une composition chimique comprenant 58,8% en poids d'acide acétique, 40% en poids d'acide méthane sulfonique (concentration de 70%), et 1,2% en poids de fluorure d'ammonium.

Des plots 1A de connexion en aluminium sont reliés à la structure précédente, et sont exposés à la composition lors du nettoyage. Il est donc nécessaire de retirer la couche de passivation 2 du puits 4 sans attaquer l'aluminium du plot.

On découpe dans la structure des coupons de 2 centimètres par 2 centimètres que l'on plonge dans la composition.

Après immersion pendant 2 minutes à température ambiante sous légère agitation et séchage, la résine 5 est retirée avec une solution inerte aux composés inorganiques, et les coupons sont observés au microscope électronique à balayage afin d'évaluer l'efficacité du nettoyage.

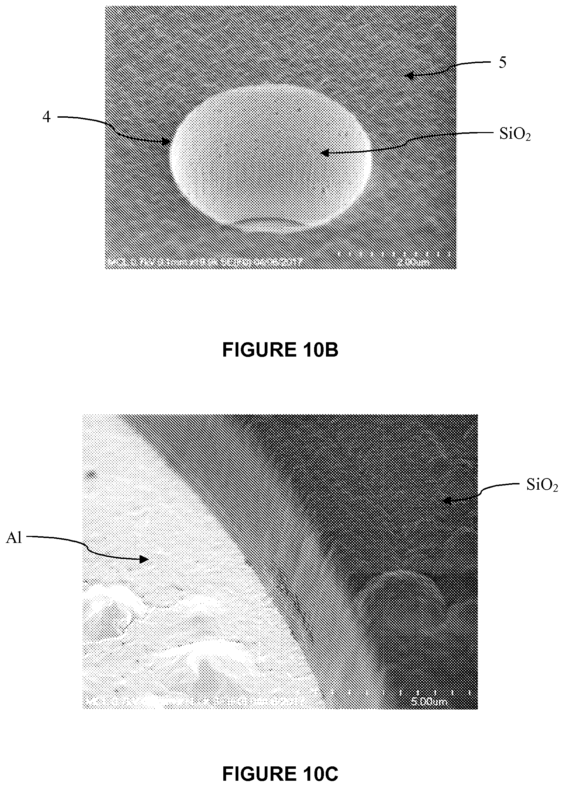

Les images obtenues sont représentées sur les Figures 10B et 10C. La Figure 10A sert de référence et représente un coupon avant nettoyage.

Sur la Figure 10A, on observe que la couche de passivation 2 recouvre la paroi latérale du puits 4. Elle recouvre la paroi latérale de SiO₂ et la paroi latérale de la résine sus-jacente.

Sur la Figure 10B, après retrait de la résine 5, on observe qu'il n'y plus de couche de passivation 2 sur la surface latérale de SiO₂, celle-ci ayant été entièrement retirée par la composition de l'invention lors du nettoyage. De plus, il n'y a pas de signe visible d'attaque de SiO₂.

La Figure 10C est centrée sur le plot 1A en aluminium. On constate qu'il n'y a pas de signe visible d'attaque de l'aluminium.

Les vitesses de gravure de l'aluminium (plot 1A) et de SiO₂ (puits 4) ont été déterminées par mesure 4 pointes et réflectométrie selon les protocoles détaillés dans l'exemple (I), et sont égales respectivement à 12 Angström par minute pour l'aluminium et 10 Angström par minute pour SiO₂, d'où un retrait d'une épaisseur d'aluminium d'environ 24 Angström, soit 0,0024 micromètres, et d'une épaisseur de SiO₂ de 20 Angström, soit 0,0020 micromètres, en 2 minutes. Cette très faible perte se traduit par le fait que, visuellement, la morphologie du plot et du puits reste inchangée.

### REFERENCES

US2016/0163533

## Revendications

1. Composition chimique de nettoyage adaptée pour retirer d'un substrat (1A, 1B, 4) une couche de passivation (2), la couche de passivation comprend des résidus de gravure résultant d'une gravure dudit substrat (1A, 1B, 4), la couche de passivation comprend un ou plusieurs des éléments chimiques choisi parmi le tantale, l'hafnium et le zirconium, **caractérisée en ce que** la composition comprend :
- un acide faible choisi parmi l'acide acétique et le mélange d'acide acétique et d'acide formique, la teneur de l'acide faible étant comprise entre 20% en poids et 95% en poids, de préférence entre 50% en poids et 80% en poids, par rapport au poids de la composition chimique,
- un acide fort non oxydant choisi parmi l'acide méthane sulfonique ayant une concentration comprise entre 60% en poids et 80% en poids, et le mélange d'acide méthane sulfonique ayant une concentration comprise entre 60% en poids et 80% en poids et d'acide chlorhydrique, ayant une concentration comprise entre 30% en poids et 40% en poids, la teneur de l'acide fort non oxydant étant comprise entre 5% en poids et 50% en poids, de préférence entre 15% en poids et 50% en poids, par rapport au poids de la composition chimique,
- de l'acide fluorhydrique, à une teneur comprise entre 0,2% en poids et 2% en poids par rapport au poids de la composition chimique,
- de l'eau, à une teneur comprise entre 2% en poids et 20% en poids par rapport au poids de la composition chimique.

2. Procédé de nettoyage pour retirer d'un substrat (1A, 1B, 4) une couche de passivation (2) comprenant des résidus de gravure résultant d'une gravure dudit substrat (1A, 1B, 4), la couche de passivation comprend un ou plusieurs des éléments chimiques choisi parmi le tantale, l'hafnium et le zirconium, **caractérisé en ce qu'**il comprend les étapes suivantes :
- fournir une composition chimique de nettoyage selon la revendication 1,
- mettre en contact la composition chimique de nettoyage et la couche de passivation (2) pendant une durée suffisante pour retirer ladite couche de passivation (2) du substrat (1A, 1B, 4).

3. Procédé selon la revendication 2, comprenant, préalablement à l'étape de mise en contact, une étape de gravure par plasma d'une couche ou d'un empilement de couches du substrat (1A, 1B, 4) dont résulte la couche de passivation (2) par interaction des ions du plasma avec la couche ou au moins une des couches de l'empilement de couches du substrat (1A, 1B, 4).

4. Procédé selon l'une des revendications 2 à 3, dans lequel lors de sa mise en contact avec la couche de passivation (2), la composition chimique est à une température comprise entre 20°C et 40°C, de préférence entre 20°C et 30°C.

5. Procédé selon la revendication 3, dans lequel les matériaux constitutifs de la couche gravée ou de l'empilement de couches gravées du substrat (1A, 1B, 4) sont choisis parmi un ou plusieurs des matériaux suivants : les métaux, les oxydes métalliques, les matériaux semi-conducteurs, les oxydes de matériaux semi-conducteurs.

6. Procédé selon la revendication 3, dans lequel les matériaux constitutifs de la couche gravée ou de l'empilement de couches gravées du substrat (1A, 1B, 4) comprennent de l'aluminium et/ou du cuivre.

## Patentansprüche

1. Chemische Reinigungszusammensetzung, die geeignet ist, von einem Substrat (1A, 1B, 4) eine Passivierungsschicht (2) zu entfernen, wobei die Passivierungsschicht Ätzrückstände umfasst, die sich aus dem Ätzen des Substrats (1A, 1B, 4) ergeben, wobei die Passivierungsschicht eines oder mehrere der chemischen Elemente umfasst, die aus Tantal, Hafnium und Zirkonium ausgewählt sind, **dadurch gekennzeichnet, dass** die Zusammensetzung Folgendes umfasst:
- eine schwache Säure, ausgewählt aus Essigsäure und dem Gemisch aus Essigsäure und Ameisensäure, wobei der Gehalt der schwachen Säure zwischen 20 Gew.-% und 95 Gew.-%, vorzugsweise zwischen 50 Gew.-% und 80 Gew.-%, bezogen auf das Gewicht der chemischen Zusammensetzung, liegt,
- eine nicht-oxidierende starke Säure, ausgewählt aus Methansulfonsäure mit einer Konzentration zwischen 60 Gew.-% und 80 Gew.-%, und dem Gemisch aus Methansulfonsäure mit einer Konzentration zwischen 60 Gew.-% und 80 Gew.-% und Salzsäure mit einer Konzentration zwischen 30 Gew.-% und 40 Gew.-%, wobei der Gehalt der nicht-oxidierenden starken Säure zwischen 5 Gew.-% und 50 Gew.-%, vorzugsweise zwischen 15 Gew.-% und 50 Gew.-%, bezogen auf das Gewicht der chemischen Zusammensetzung, liegt,
- Fluorwasserstoffsäure, mit einem Gehalt zwischen 0,2 Gew.-% und 2 Gew.-%, bezogen auf das Gewicht der chemischen Zusammensetzung,
- Wasser, mit einem Gehalt zwischen 2 Gew.-% und 20 Gew.-%, bezogen auf das Gewicht der chemischen Zusammensetzung.

2. Reinigungsverfahren zum Entfernen einer Passivierungsschicht (2) von einem Substrat (1A, 1B, 4), die Ätzrückstände umfasst, die sich aus dem Ätzen des Substrats (1A, 1B, 4) ergeben, wobei die Passivierungsschicht eines oder mehrere der chemischen Elemente umfasst, die aus Tantal, Hafnium und Zirkonium ausgewählt sind, **dadurch gekennzeichnet, dass** es die folgenden Schritte umfasst:
- Bereitstellen einer chemischen Reinigungszusammensetzung nach Anspruch 1,
- Inkontaktbringen der chemischen Reinigungszusammensetzung und der Passivierungsschicht (2) für eine Zeit, die ausreicht, um die Passivierungsschicht (2) von dem Substrat (1A, 1B, 4) zu entfernen.

3. Verfahren nach Anspruch 2, umfassend vor dem Schritt des Inkontaktbringens einen Schritt des Plasmaätzens einer Schicht oder eines Schichtstapels des Substrats (1A, 1B, 4), aus dem sich die Passivierungsschicht (2) durch Wechselwirkung der Ionen des Plasmas mit der Schicht oder mindestens einer der Schichten des Schichtstapels des Substrats (1A, 1B, 4) ergibt.

4. Verfahren nach einem der Ansprüche 2 bis 3, wobei die chemische Zusammensetzung eine Temperatur zwischen 20 °C und 40 °C, vorzugsweise zwischen 20 °C und 30 °C, aufweist, wenn sie mit der Passivierungsschicht (2) in Kontakt gebracht wird.

5. Verfahren nach Anspruch 3, wobei die Materialien, die die geätzte Schicht oder den geätzten Schichtstapel des Substrats (1A, 1 B, 4) bilden, aus einem oder mehreren der folgenden Materialien ausgewählt sind: Metalle, Metalloxide, Halbleitermaterialien, Oxide von Halbleitermaterialien.

6. Verfahren nach Anspruch 3, wobei die Materialien, die die geätzte Schicht oder den geätzten Schichtstapel des Substrats (1A, 1 B, 4) bilden, aus Aluminium und/oder Kupfer bestehen.

## Claims

1. A cleaning chemical composition adapted to remove a passivation layer (2) from a substrate (1A, 1B, 4), the passivation layer comprises etching residues resulting from etching said substrate (1A, 1B, 4), the passivation layer comprises one or more of the chemical elements selected from tantalum, hafnium and zirconium, **characterised in that** the composition comprises:
- a weak acid selected from acetic acid and the mixture of acetic acid and formic acid, the content of the weak acid being between 20% by weight and 95% by weight, preferably between 50% by weight and 80% by weight, based on the weight of the chemical composition,
- a non-oxidizing strong acid selected from methane sulphonic acid having a concentration of between 60% by weight and 80% by weight, and the mixture of methane sulphonic acid having a concentration of between 60% by weight and 80% by weight and hydrochloric acid, having a concentration of between 30% by weight and 40% by weight, the content of the non-oxidizing strong acid being between 5% by weight and 50% by weight, preferably between 15% by weight and 50% by weight, based on the weight of the chemical composition,
- hydrofluoric acid, in a content of between 0.2% by weight and 2% by weight based on the weight of the chemical composition,
- water, in a content of between 2% by weight and 20% by weight based on the chemical composition.

2. A cleaning process for removing from a substrate (1A, 1B, 4)a passivation layer (2) comprising etching residues resulting from etching said substrate (1A, 1B, 4), the passivation layer comprises one or more of the chemical elements selected from tantalum, hafnium and zirconium, **characterized in that** it comprises the following steps of:
- providing a chemical cleaning composition according to claim 1,
- contacting the cleaning chemical composition with the passivation layer (2) for a sufficient time to remove said passivation layer (2) from the substrate (1A, 1B, 4).

3. The process according to claim 2, comprising, prior to the contacting step, a step of plasma etching a layer or a stack of layers of the substrate (1A, 1B, 4) from which the passivation layer (2) results by interaction of the plasma ions with the layer or at least one of the layers of the stack of layers of the substrate (1A, 1B, 4).

4. The process according to one of claims 2 to 3, wherein upon contacting with the passivation layer (2), the chemical composition is at a temperature between 20°C and 40°C, preferably between 20°C and 30°C.

5. The process according to claim 3, wherein the materials making up the etched layer or the stack of etched layers of the substrate (1A, 1B, 4) are selected from one or more of the following materials: metals, metal oxides, semiconductor materials, oxides of semiconductor materials.

6. The process according to claim 3, wherein the materials making up the etched layer or of the stack of etched layers of the substrate (1A, 1B, 4) comprise aluminium and/or copper.
